(19) Europäisches Patentamt
European Patent Office
Office européen des brevets

(11) Publication number: 0 200 477
A2

(12) EUROPEAN PATENT APPLICATION

(21) Application number: 86303091.2

(22) Date of filing: 24.04.86

(51) Int. Cl.$^4$: G 03 F 7/02

(30) Priority: 26.04.85 JP 88515/85

(43) Date of publication of application:
05.11.86 Bulletin 86/45

(84) Designated Contracting States:
DE FR GB

(71) Applicant: HITACHI, LTD.
6, Kanda Surugadai 4-chome Chiyoda-ku
Tokyo 100(JP)

(72) Inventor: Nishida, Takashi
3-5-2 Nakaya
Taito-ku Tokyo(JP)

(72) Inventor: Mukai, Kiichiro
2-24-14, Akatsuki-cho
Hachioji-shi Tokyo(JP)

(72) Inventor: Honma, Yukio
2196-58, Hirai, Hinode-machi
Nishitama-gun, Tokyo(JP)

(74) Representative: Paget, Hugh Charles Edward et al,
MEWBURN ELLIS & CO. 2/3 Cursitor Street
London EC4A 1BQ(GB)

(54) **Process for pattern formation.**

(57) A predetermined pattern is formed by effecting patterning of a thermosetting resin film or a film (11) formed on a thermosetting resin film (3). A multilayer resist process is used in which a thermoplastic resin film (10) is used as the bottom layer. This use of a thermoplastic resin is advantageous because the thermoplastic resin film alone can be selectively removed by dissolution in an organic solvent, so that the bottom layer can be removed without detriment to the thermosetting resin film (3).

*FIG. 1c*

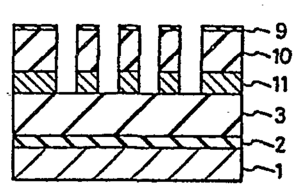


EP 0 200 477 A2

## Title of the Invention

# PROCESS FOR PATTERN FORMATION

## Background of the Invention

The present invention relates to a process for pattern formation, and more specifically to a process for pattern formation in which a film of a thermosetting resin such as a polyimide resin, or a film of an article formed on a film of a thermosetting resin such as a polyimide resin and to be processed is formed into a predetermined pattern by a multi-layer resist process.

Fine processing of a polyimide resin has heretofore be performed by processing a thin metallic or inorganic film formed on a polyimide resin film according to an ordinary photoetching technique and processing the polyimide resin by using the processed film as a mask, as disclosed in Japanese Patent Publication No. 58,412/1983.

The ordinary photoetching technique has also been employed in forming, for example, a wiring pattern on a polyimide resin. This is because planarization of the surface of a base in a multi-layer resist process is unnecessary in forming a pattern by removing a predetermined portion of a polyimide resin film or a metallic film formed thereon by etching since

the polyimide resin itself has a planarizing ability. These days when the minimum feature size has been reduced to 1 $\mu$m or less, however, the use of the multi-layer process becomes necessary particularly in order to form a metallic wiring pattern on a polyimide resin film with a high accuracy. The multi-layer resist process which is now employed generally comprises thickly coating a photoresist (for example, based on a phenol novolak resin) to planarize the surface of a base, heat-treating the same at 200°C or higher to form a so-called bottom layer, forming thereon in sequence a film (middle layer) made of a material highly resistant to dry etching employed for etching the bottom layer and to serve as a mask in etching of the bottom layer and a top layer (photoresist or electron beam resist film) for removing the predetermined portion of the middle layer to form the above-mentioned mask, as described in, for example, Japanese Patent Laid-Open No. 78,531/1984. Since the heat-treated photoresist is generally insoluble in common organic solvents, the above-mentioned bottom layer is in general removed by using an oxygen plasma after formation of a predetermined pattern such as a wiring pattern. This is also performed when other polymer resin is used in the bottom layer. However, when

this process is employed in formation of a polyimide resin pattern or, for example, an Al wiring pattern on a polyimide resin layer, even the necessary polyimide resin are disadvantageously reduced to ashes and removed in the removal of the bottom layer.

## Summary of the Invention

An object of the present invention is to provide a multi-layer resist process which can overcome the disadvantage of the prior art that a thermosetting resin such as a polyimide resin is also removed in removal of a bottom layer.

According to the present invention, a heat-resistant thermoplastic resin is used as a bottom layer (lower film) in the multi-layer resist process to make it possible to remove the bottom layer without removal of a polyimide or other thermosetting resin film which supports or forms the layer in which the pattern is formed. This utilizes for example such properties of the heat-resistant thermoplastic resin that it can sufficiently resist a heat treatment of SOG (spin on glass) at 200°C and is sufficiently soluble in an organic solvent even after the heat treatment.

Embodiments of the invention are described by way of example with reference to the accompanying drawings.

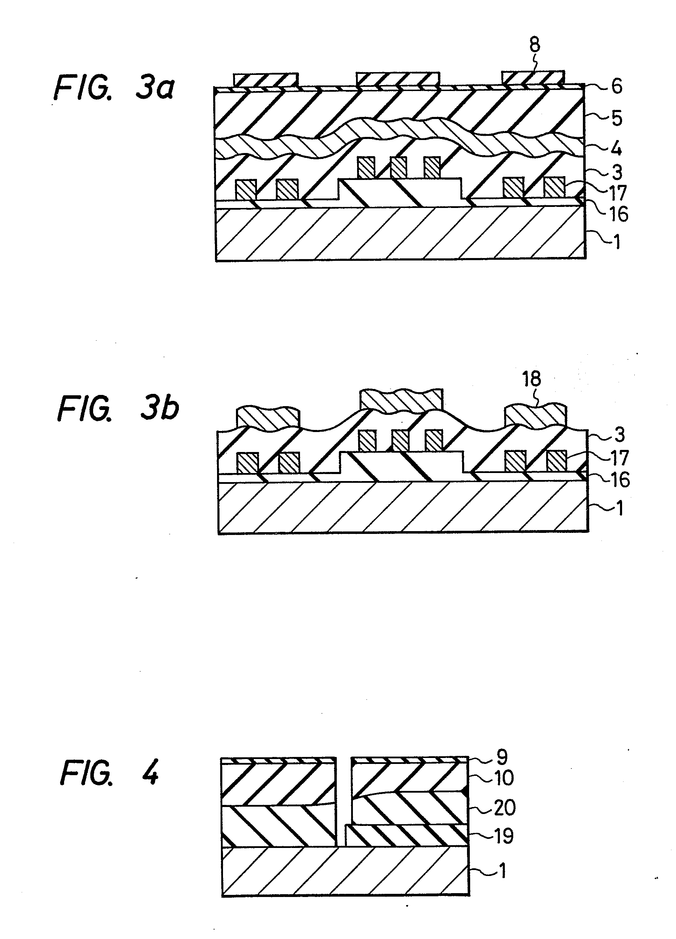

Figs. 1a to 1d are process diagrams illustrating an example of the process of the present invention. Figs. 2a and 2b are diagrams showing the results

when a conventional material is used in the bottom layer for comparison. Figs. 3a and 3b, and Fig. 4 are diagrams illustrating other examples of the process of the present invention.

Example 1

As shown in Fig. 1a, a film 3 of a polyimide isoindoloquinazolinedione resin (hereinafter referred to as "PII resin"; the resin used in this example is PIQ (registered trade mark) manufactured by Hitachi Chemical Co., Ltd.), which is a kind of polyimide resin, was formed by spin coating on an Si wafer 1 having a thermally oxidized film 2 formed on the surface thereof, and cured at 350°C to provide a thickness of 2 μm. Subsequently, an Al film 4 having a thickness of 1 μm was formed by sputtering deposition.

A dimethylacetamide solution (resin content: 20 %) of an aromatic polysulfone resin:

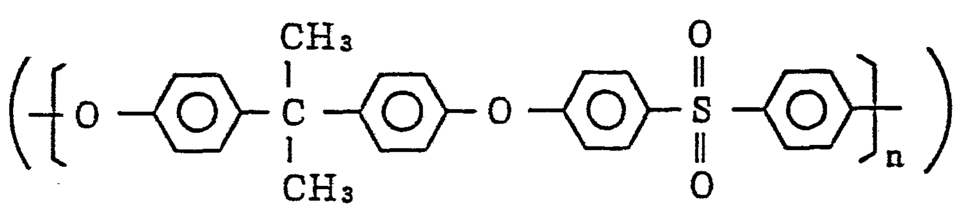

was spin-coated and heat-treated at 200°C for 30 minutes to form an aromatic polysulfone resin film 5

having a thickness of about 2.2 $\mu$m, on which a film 6 of coated glass (spin on glass; hereinafter referred to as "SOG") having a thickness of 0.1 $\mu$m was then formed by spin coating. A photoresist film 7 was formed according to an ordinary photoresist process.

The above-mentioned photoresist film was treated according to known light exposure and development to form a photoresist pattern 8 as shown in Fig. 1b. A pattern 9 of SOG was formed by dry etching with a fluorine-containing gas, such as $CF_4$, as the etching gas and with the above-mentioned photoresist film 8 as the mask. A pattern 10 of the above-mentioned aromatic polysulfone resin baked at 200°C was then obtained by reactive ion etching with oxygen as the etching gas and with the SOG pattern 9 as the mask. In this step, the photoresist pattern 8 as the upper layer was removed by etching with oxygen. The exposed portion of the Al film 4 was removed by dry etching with a Cl-containing gas as the etching gas and with the aromatic polysulfone resin pattern 10 as the mask to form a desired Al pattern 11 as shown in Fig. 1c. Thereafter, the polysulfone resin pattern 10 was dissolved by immersion in dimethylacetamide to remove the polysulfone pattern 10 together with the coated glass pattern 9 formed thereon, as shown

in Fig. 1d. The obtained Al pattern 11 had a dimensional difference of 0.1 μm or less with the photoresist pattern 8 to confirm the formation thereof with a high accuracy.

For comparison, the results obtained according to a conventional multi-layer resist process are illustrated in Figs. 2a and 2b.

AZ1350J, which is a kind of photoresist, was used in a bottom layer instead of the above-mentioned aromatic polysulfone resin. The same treatment as in Example 1 was performed to remove the exposed portion of the Al film 4. Thereafter, a pattern of a cured film of the above-mentioned AZ1350J as the bottom layer was removed by oxygen plasma, which reduced the PII film beneath the Al pattern 11 together with the AZ1350J film as the bottom layer to ashes and removed them to form a hollow portion 13 as shown in Fig. 2a. The Al pattern 12 was also removed together with the above-mentioned AZ1350J film so that no wirings could be formed on the PII film 3.

When removal of the AZ1350J film as the bottom layer was performed by immersion in hydrazine hydrate instead of the above-mentioned oxygen plasma, the surface portion 15 of the PII film 3 was swollen due to formation of a hydrazide so that the Al pattern

14 formed thereon was peeled off. Thus, no wirings were formed in this case, either.

Although the use of dimethylacetamide as the solvent of the polysulfone resin has been exemplified in this example, the polysulfone resin could also be removed by using a solvent such as acetophenone, chloroform, cyclohexanone, chlorobenzene, or N-methyl-2-pyrrolidinone without any influence on the PII resin.

Example 2

An Al pattern was formed in substantially the sme manner as in Example 1 except that a polyphenylene oxide resin:

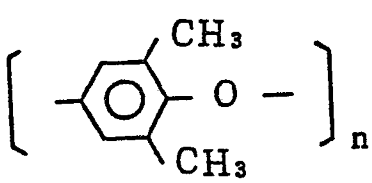

was used instead of the polysulfone resin. The Al pattern could be formed with a high accuracy. Toluene as well as dichloroethylene could be used as the solvent for removing the bottom layer.

Example 3

An Al pattern with a high accuracy could be formed in substantially the same manner as in

Example 1 except that a polybenzimidazole resin:

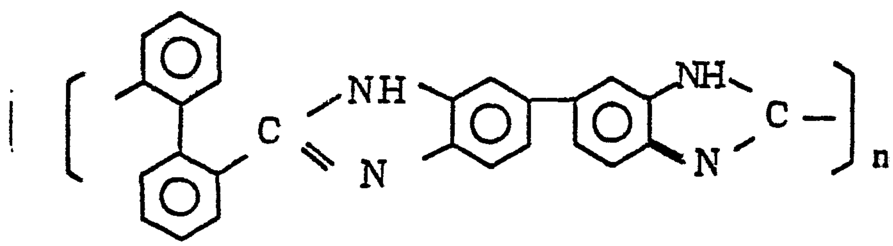

was used instead of the polysulfone resin to form a bottom layer. Dimethylformamide as well as dimethylacetamide could be used as the solvent for removing the bottom layer.

Example 4

As shown in Fig. 3a, a PII resin film 3 was formed on an Si wafer 1 having a stepped silicon dioxide film 16 with a step difference of 1.2 μm on the surface thereof and Al wirings 17 formed thereon and having a thickness of 1 μm, and cured at 350°C to form a cured film having a thickness of 2 μm, followed by formation thereon of an Al film 4 having a thickness of 1 μm by sputtering deposition. Thereafter, as shown in Fig. 3b, an Al pattern 18 was formed on the high- and low-step portions according to a multi-layer resist process in which a polysulfone resin film 5 was used as the bottom layer as in Example 1. The dimension of the photoresist pattern

8 formed on the upper as well as lower side of the step could be controlled with an accuracy within the range of ±0.05 μm as against that of the mask due to the planarization effect of the polysulfone resin used as the bottom layer. A dimensional difference between the Al pattern 18 and the photoresist pattern 8 was 0.1 μm or less. Thus, the Al pattern was formed with a high accuracy on the upper as well as lower portion of the step. It was confirmed that an Al pattern 18 with lines and spaces of 0.6 μm, which are close to the limits in the optical exposure system, could be formed.

On the other hand, when an Al film on the PII resin was directly processed with a photoresist as the mask, the dimension of the photoresist pattern varied within a range of ±0.18 μm as against that of the mask because of variation in the thickness of the photoresist caused by the roughness of the base. Local short circuit was observed even in an Al pattern with lines and spaces of 1 μm in some cases.

Example 5

While an Al pattern was formed on a polyimide film in any one of the above-mentioned Examples, a polyimide film was accurately processed according

to a multi-layer resist process in this Example.

Accurate processing of the polyimide resin film is necessary, for example, where a contact hole is formed in an interlayer insulating film consisting of, for example, a polyimide resin film.

As shown in Fig. 4, a PII resin film 20 was formed on an Si wafer 1a having a pattern 19 of a silicon dioxide film by spin coating, and cured at 350°C to form a cured film having a thickness of 2 $\mu$m. A fine pattern of the PII resin film 20 could be formed even on the stepped portions with a good accuracy according to the multi-layer resist process in which a polysulfone resin film 10 was used as the bottom layer as in Example 1. The polysulfone resin could be easily removed by using N-methyl-2-pyrrolidinone as the solvent.

Although only the use of a PII resin was exemplified in the above-mentioned Examples, the same effect can be obtained by using other polyimide resin or polyimide type resin. Besides those mentioned in the Examples, any heat-resistant thermoplastic resin can be used as the resin for the bottom layer in so far as it is soluble in an organic solvent even after being subjected to the steps of the multi-layer resist process.

The resin used in the bottom layer in the present invention has properties that it softens above a given temperature, and that it is soluble in an organic solvent even after a heat treatment. Resins having such properties are called "thermoplastic resins".

On the other hand, resins including polyimide resins are cured according to a crosslinking reaction when the temperature is raised,so that they become insoluble in any organic solvents. Resins having such properties are called "thermosetting resins". The main feature of the present invention consists in that a pattern of a thermosetting resin film or other material, such as a metal or polycrystalline silicon, on a thermosetting resin film is formed according to a multi-layer resist process involving the use of a thermoplastic resin film as the bottom layer.

The thermoplastic resin to be used in the present invention preferably has a heat resistance above a given level.

Specifically, when SOG is used in formation of the above-mentioned middle layer, the above-mentioned thermoplastic resin is not desired to be softened at a temperature of about 220 to 230°C to which heating is effected in formation of the middle layer.

Further, surface planarization is sometimes effected by heating at about 250 to 300°C after formation of the above-mentioned thermoplastic resin film as the bottom layer by spin coating to allow the thermoplastic resin to flow.

The thermoplastic resin to be used in the present invention is desired neither to give rise to a crosslinking reaction leading to curing nor to be decomposed or degraded to evaporate even when heat-treated.

Thus, heat-resistant thermoplastic resins usable in the present invention may be those which do not soften at about 200 to 230°C, and which do not give rise to a crosslinking nor decomposition reaction at about 250 to 300°C.

Usable resins meeting such conditions include not only polysulfone, polyphenylene oxide, and polybenzimidazole resins as used in the above-mentioned Examples, but also a polycarbonate resin.

A film of a material highly resistant to dry etching performed for removal of a predetermined portion of the bottom layer is used for example as the above-mentioned middle layer. Examples of such a material include not only SOG as used in the above-mentioned Examples, but also many other materials usable as the middle layer in the ordinary multi-layer resist

process, such as phosphosilicate glass, polycrystalline silicon, silicon dioxide, and silicon nitride.

Needless to say, the organic solvent for removal of the residual bottom layer is not limited to those as used in the above-mentioned Examples, and can be appropriately chosen depending on the kind of thermoplastic resin used in the bottom layer.

Usable materials of the top layer are those capable of changing their solubility upon irradiation with light, electron beams, X-rays, or ion beams (generically referred to as "light"), such as a photoresist and a electron beam resist. Particularly a resist containing silicon can be used as the mask in selective etching of a predetermined portion of the bottom layer, since it has a high dry ethcing resistance. In this case, the above-mentioned middle layer is unnecessary so that the process of the present invention is greatly simplified.

CLAIMS

1. A process for pattern formation in a film (4;20), comprising the steps of

(a) coating a resin onto said film (4;20) in which the pattern is to be formed and heat treating the resin to form a bottom layer (5) on said film;

(b) forming on said bottom layer (5) a mask (9) made of a material having a dry etching resistance higher than that of said bottom layer;

(c) removing an exposed portion of said bottom layer (5) by dry etching;

(d) removing an exposed portion of said film (4;20) to produce the pattern; and

(e) removing the remaining portion of said bottom layer (5) with an organic solvent;

characterized in that

said film in which the pattern is formed is a film (4) formed on a thermosetting resin film (3) or is itself a thermosetting resin film (20) and in that said resin of which the bottom layer (5) is formed is a thermoplastic resin.

2. A process as claimed in claim 1 wherein said mask (9) is formed by

forming on said bottom layer (5) a middle layer (6) made of a material having a dry etching resistance higher than that of said bottom layer;

forming on said middle layer a top layer (7) made of a material capable of changing its solubility upon irradiation with light;

selectively removing a predetermined portion of said top layer (7) by light exposure and development; and

removing an exposed portion of said middle layer (6) to form the mask.

3. A process as claimed in claim 1 or claim 2 wherein said thermosetting resin is a polyimide resin.

4. A process as claimed in claim 3 wherein said polyimide resin is a polyimide isoindoloquinazolinedione resin.

5. A process as claimed in any one of claims 1 to 4 wherein said thermoplastic resin is selected from polysulfone, polyphenylene oxide, polybenzimidazole and polycarbonate resins.

6. A process as claimed in any one of claims 1 to 5 wherein said mask is a film made of SOG, phosphosilicate glass, polycrystalline silicon, silicon dioxide or silicon nitride.

7. A process as claimed in any one of claims 1 to 6, wherein in step (c) said exposed portion of said bottom layer is removed by oxygen plasma.

FIG. 1a

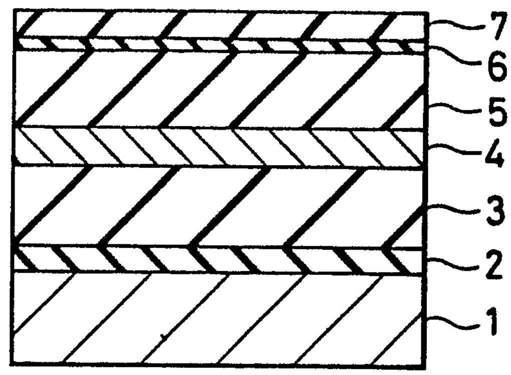


FIG. 1b

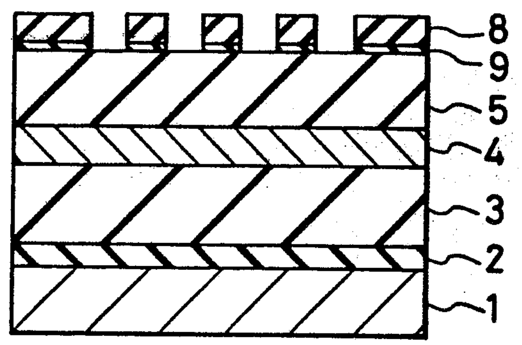


FIG. 1c

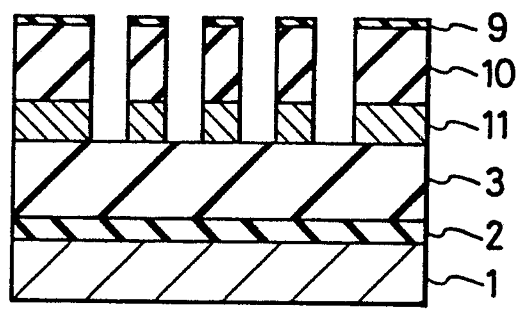


FIG. 1d

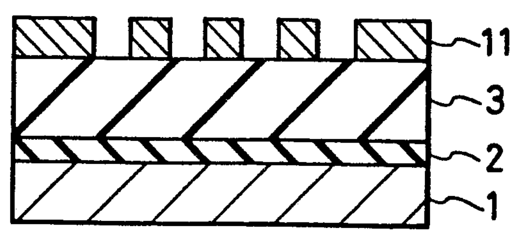

FIG. 2a

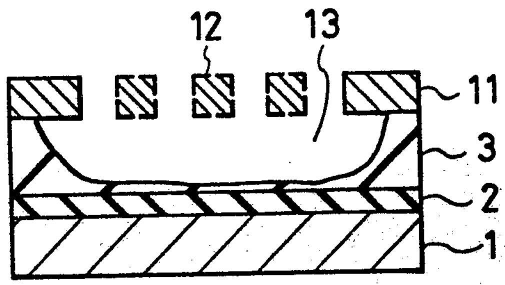


FIG. 2b

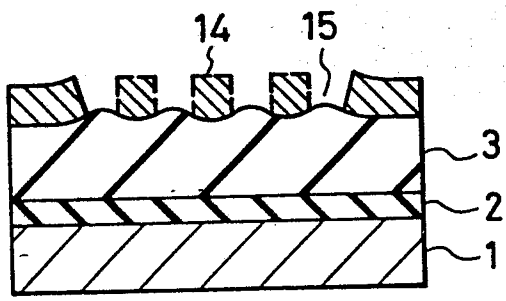

FIG. 3a

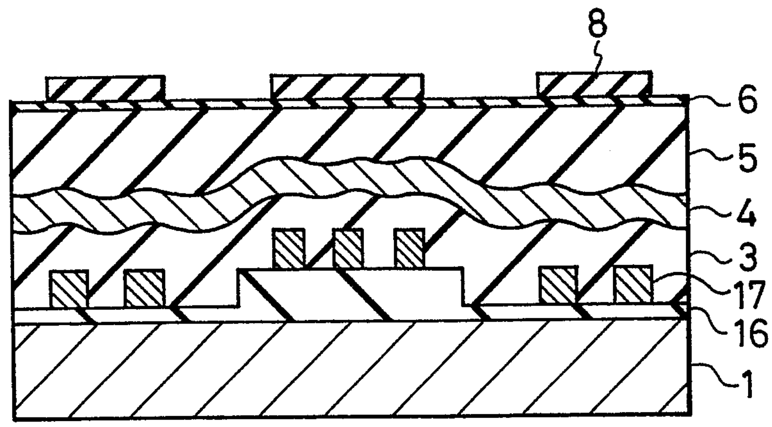


FIG. 3b

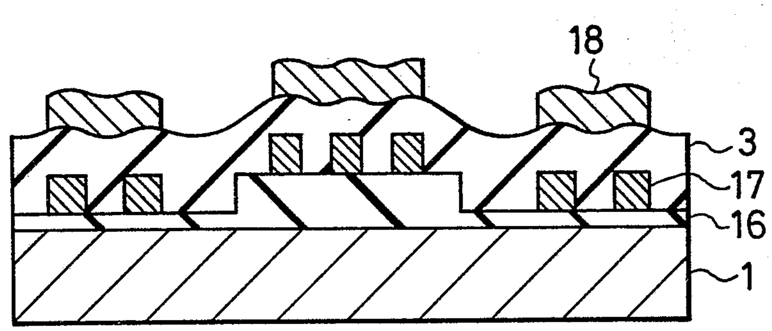


FIG. 4